# EUROPEAN PATENT SPECIFICATION

(11) **EP 2 397 580 B1**
(45) Date of publication and mention of the grant of the patent: **24.01.2018**
(21) Application number: 11169731.4
(22) Date of filing: 14.06.2011
(51) Int. Cl.: C30B 15/00, C30B 15/06, C30B 15/14, C30B 29/06

(54) **Method and apparatus for manufacturing a silicon substrate with excellent surface quality using inert gas blowing**
Verfahren und Vorrichtung zur Herstellung eines Silicium-Substrats mit ausgezeichneter Oberflächenqualität mittels Intertgasblasverfahren
Procédé et appareil de fabrication de substrat en silicium ayant une excellente qualité de surface à l'aide d'un soufflage à gaz inerte

(30) Priority: 14.06.2010 KR 20100055949; 10.06.2011 KR 20110056067
(43) Date of publication of application: 21.12.2011
(73) Proprietor: Korea Institute of Energy Research, Daejon 305-343 (KR)
(72) Inventor: Jang, Bo-Yun, 305-330 Daejeon (KR); Lee, Jin-Seok, 301-080 Daejeon (KR); Ahn, Young-Soo, 305-509 Daejeon (KR)
(74) Representative: Plougmann Vingtoft a/s

(56) References cited:
- EP-A1- 2 128 088
- US-A- 4 670 096
- US-A- 4 789 022
- US-A1- 2008 236 665

## Description

### BACKGROUND

### 1. Technical Field

The present invention relates to a technique for manufacturing a silicon substrate and, more particularly, to a method and apparatus for manufacturing a silicon substrate using inert gas blowing during continuous casting to provide excellent productivity and surface quality.

### 2. Description of the Related Art

A silicon substrate is a main component of a silicon solar cell and constitutes about 28% of the price of a solar cell module.

Generally, a silicon substrate for solar cells is manufactured by melting raw silicon and solidifying molten silicon to prepare a single crystalline silicon ingot or polycrystalline silicon block, which in turn is subjected to several cutting processes.

In conventional methods of manufacturing a silicon substrate, about 40∼50% of the raw silicon is removed as Kerf-loss through the cutting processes, causing an increase in manufacturing costs.

To prevent Kerf-loss, a technique of directly manufacturing a silicon substrate from molten silicon has been developed.

Currently, a technique for directly manufacturing a silicon substrate from molten silicon can be classified into a vertical growth type and a horizontal growth type. The vertical growth technique has already been used in the art but has a problem of low growth speed. On the other hand, the horizontal growth technique is not used in the art, despite high growth speed.

As the horizontal growth type technique for directly manufacturing a silicon substrate, a ribbon growth on substrate (RGS) process is representatively used. In the RGS process, solidification of molten silicon is controlled in a molten silicon container and shape control is performed using a blade, thereby causing the following problems.

First, in the RGS process, it is necessary to control solidification time to millisecond (msec) precision or less for solidification of the molten silicon within the container. If the solidification time slightly exceeds a preset duration, a solidified substrate is likely to be trapped by a blade, causing a failure of solidification equipment.

Further, uniform solidification is obtained by uniform adjustment of the temperature of the molten silicon over the whole of the substrate. However, it is very difficult to obtain uniform control of the molten silicon having high fluidity.

Further, the RGS process employs the blade for shape control of the substrate. In this case, there is a high possibility of blade failure and mechanical contact between the blade and the silicon substrate is likely to cause contamination of the substrate.

US 4789022 discloses a process for continuous casting of metal ribbon by the steps of feeding the molten metal onto the surface of a moving support while heating the support so that its temperature exceeds the solidification temperature of the metal, and cooling at a downstream position.

EP 2128088 A1 discloses an apparatus and a method for manufacturing silicon substgrate.

US 2008/0236665 A1 discloses a method for rapid liquid phase deposition of crystalline Si thin films on large glass substrates for solar cell applications.

US 4670096 discloses a process and an apparatus for producing semi-conductor foils.

### BRIEF SUMMARY

One aspect of the invention is to provide an apparatus for manufacturing a silicon substrate, which can directly manufacture a silicon substrate from molten silicon using inert gas blowing during continuous casting to improve surface quality of the silicon substrate.

Another aspect of the invention is to provide a silicon substrate manufacturing method which can improve surface quality of a silicon substrate using inert gas blowing.

In accordance with one embodiment, there is provided an apparatus for manufacturing a silicon substrate using inert gas blowing which provides excellent surface quality. The apparatus includes a raw silicon feeder through which raw silicon is fed; a silicon melting unit disposed under the raw silicon feeder and melting the raw silicon to form molten silicon; a molten silicon storage unit storing the molten silicon supplied from the silicon melting unit and tapping the molten silicon to provide a silicon melt having a constant thickness; a transfer unit transferring the silicon melt tapped from the molten silicon storage unit; and a cooling unit cooling the silicon melt transferred by the transfer unit. Here, the cooling unit cools the silicon melt by blowing inert gas at a rate of 0.1∼3 Nm³/h.

In accordance with another embodiment, there is provided a method of manufacturing a silicon substrate using inert gas blowing which provides excellent surface quality. The method includes: (a) supplying raw silicon into the silicon melting unit; (b) melting the raw silicon placed in the silicon melting unit to form molten silicon; (c) opening a gate of the silicon melting unit to tap the molten silicon; (d) storing the tapped molten silicon in the molten silicon storage unit; (e) driving the transfer unit to eject the molten silicon; and (f) cooling the molten silicon by blowing inert gas to the molten silicon transferred by the transfer unit. The inert gas is blown at a rate of 0.1∼3 Nm³/h.

### BRIEF DESCRIPTION OF THE DRAWINGS

The above and other aspects, features, and advantages of the invention will become apparent from the detailed description of the following embodiments in conjunction with the accompanying drawings:
Fig. 1 is a schematic view of an apparatus for manufacturing a silicon substrate using inert gas blowing according to one exemplary embodiment of the present invention;
Fig. 2 is a flowchart of a method of manufacturing a silicon substrate using inert gas blowing according to one exemplary embodiment of the present invention;
Fig. 3 is a micrograph showing the microstructure of a surface of a silicon substrate manufactured by the apparatus according to the exemplary embodiment of the present invention;
Fig. 4 is a micrograph showing the microstructure of a cross-section of the silicon substrate of Fig. 3;
Fig. 5 is a picture showing the surface of a silicon substrate manufactured without application of inert gas blowing;
Fig. 6 is a picture showing the surface of a silicon substrate manufactured using inert gas blowing; and
Fig. 7 is a picture showing a polished surface of the silicon substrate of Fig. 6.

### DETAILED DESCRIPTION

Exemplary embodiments of the invention will now be described in detail with reference to the accompanying drawings. It should be understood that the present invention is not limited to the following embodiments and may be embodied in different ways, and that the embodiments are given to provide complete disclosure of the invention and to provide thorough understanding of the invention to those skilled in the art. The scope of the invention is limited only by the accompanying claims and equivalents thereof. Like components will be denoted by like reference numerals throughout the specification.

Next, a method and apparatus for manufacturing a silicon substrate with excellent surface properties using inert gas blowing according to exemplary embodiments of the invention will be described with reference to the accompanying drawings.

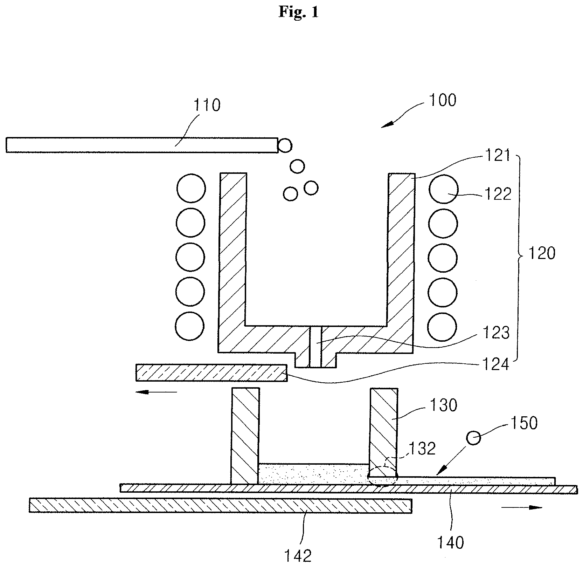

Fig. 1 is a schematic view of an apparatus for manufacturing a silicon substrate using inert gas blowing according to one exemplary embodiment of the present invention.

Referring to Fig. 1, the apparatus 100 for manufacturing a silicon substrate according to the embodiment includes a raw silicon feeder 110, a silicon melting unit 120, a molten silicon storage unit 130, a transfer unit 140, and a cooling unit 150.

The raw silicon feeder 110 receives raw silicon from outside and supplies a predetermined amount of raw silicon into the silicon melting unit 120.

The silicon melting unit 120 melts the supplied raw silicon to form molten silicon. The silicon melting unit 120 may melt the raw silicon using various heating manners such as induction heating, resistance heating, and the like. Herein, induction heating will be described as an example of a process for melting raw silicon.

Unlike metal, silicon is difficult to apply direct heating through electromagnetic induction due to low electrical conductivity of silicon at a temperature of about 700°C or less. Thus, raw silicon can be melted through indirect melting in a crucible.

For silicon melting through indirect melting, a graphite crucible may be used. Although graphite is non-metallic, excellent electrical and thermal conductivity of graphite facilitate heating of the raw silicon through electromagnetic induction. Here, when silicon is indirectly melted by heat in the graphite crucible, there is a problem of contamination of silicon or an inner surface of the crucible.

Accordingly, it is desirable that the raw silicon be subjected to indirect melting using crucible heat at a temperature of 700°C or less and subjected to non-contact melting through induction melting at a temperature exceeding 700°C to minimize the problem of contamination of the silicon.

In the case where the raw silicon is melted through induction melting, the silicon melting unit 120 may be an induction melting device that includes a crucible 121, an induction coil 122, a tapping hole 123, and a gate 124.

The crucible 121 receives the raw silicon from the feeder and has the tapping hole 123 formed at a lower side thereof. The crucible 121 may be a graphite crucible or a water-cooled crucible. Alternatively, a combination of the graphite crucible and the water-cooled crucible may be used as the crucible 121.

The induction coil 122 is wound around an outer wall of the crucible 121. The induction coil 122 is connected to an AC power source.

The gate 124 opens or closes the tapping hole 123 formed at the lower side of the crucible 121. The gate 124 may be a bar type gate, but is not limited thereto. Alternatively, the gate 124 may be a valve type gate.

The molten silicon storage unit 130 stores the molten silicon supplied from the silicon melting unit 120 and taps the molten silicon to provide a silicon melt having a constant thickness. The molten silicon storage unit 130 may be open at a lower side thereof. In this case, the transfer unit 40 disposed at the lower side of the molten silicon storage unit 130 defines the lower side of the molten silicon storage unit 130.

Further, the molten silicon storage unit 130 is formed at one side of a lower portion thereof with an ejection port 132 through which the molten silicon is ejected. The thickness of the ejection port 132 may act as a factor determining the thickness of a silicon substrate and may be in the range of about 0.1∼2 mm.

The transfer unit 140 is disposed at the lower side of the molten silicon storage unit 130 and continuously transfers the silicon melt ejected from the molten silicon storage unit 130. The transfer unit 140 may be a transfer board and employ a conveyer belt type transfer device.

When the transfer unit 140 is a transfer board, the transfer unit may be constituted by a single board or may be divided into a transfer board which is responsible for transferring the molten silicon and a lower substrate which contacts the molten silicon and forms the silicon substrate.

The transfer unit 140 may be pre-heated by a preheating unit 142 to minimize temperature difference between the silicon melt and the transfer unit.

The transfer unit 140 may be made of a material, such as C, SiC, Si₃N₄, graphite, Al₂O₃ and Mo, which have different coefficients of thermal expansion than silicon. As the transfer unit 140 has a different coefficient of thermal expansion than silicon, the silicon substrate can be easily separated from the transfer unit 140 when manufactured by cooling the silicon melt, and the transfer unit 140 can be reused.

The cooling unit 150 cools the silicon melt to form the silicon substrate.

According to one embodiment, the cooling unit 150 cools the silicon melt by blowing an inert gas such as argon, helium, nitrogen, and the like. In this case, the inert gas may be at least one selected from the group of argon, helium, nitrogen, and mixtures thereof.

Inert gas blowing may assist in removal of the remaining melt which can be formed by rapid cooling of the silicon melt and is performed to facilitate control of the surface shape of a silicon substrate manufactured through surface flattening.

The inert gas may by blown at a rate of 0.1∼3 Nm³/h. More preferably, the inert gas is blown at a rate of 0.6∼2.5 Nm³/h. If the inert gas is blown at a rate less than 0.1 Nm³/h, the silicon substrate can be excessively thickened due to inefficient inert gas blowing, thereby making it impossible to perform continuous casting. On the other hand, if the inert gas is blown at a rate exceeding 3 Nm³/h, the silicon melt is blown, thereby making it impossible to obtain continuous manufacture of the silicon substrate.

When using the apparatus shown in Fig. 1, productivity and quality of the manufactured silicon substrate can be significantly affected by process variables, such as the surface temperature of the molten silicon, the preheating temperature of the transfer unit, and the moving speed of the transfer unit. These process variables affect productivity of the silicon substrate through combinational influence rather than individual influence.

Thus, the process variables may be adjusted such that the surface temperature of the molten silicon is in the range of 1350∼1500°C, the preheating temperature of the transfer unit is in the range of 750∼1400°C, and the moving speed of the transfer unit 140 is in the range of 450∼1400 cm/min. Further, the transfer time of the silicon substrate after tapping the molten silicon from the molten silicon storage unit may be in the range of 0.5∼3.5 seconds.

If the surface temperature of the molten silicon stored in the molten silicon storage unit 130 is less than 1350°C, the molten silicon can solidify before tapping. If the surface temperature of the molten silicon exceeds 1500°C, the silicon melt can trickle down during transfer of the tapped silicon melt.

Further, if the preheating temperature of the transfer unit 140 is less than 750°C, the molten silicon can solidify at a contact portion between the transfer unit 140 and the molten silicon. On the contrary, if the preheating temperature of the transfer unit 140 exceeds 1400°C, the silicon melt can trickle down.

Further, if the moving speed of the transfer unit 140 is less than 450 cm/min, the manufactured silicon substrate can be excessively thickened. On the contrary, if the moving speed of the transfer unit 140 exceeds 1400 cm/min, the manufactured silicon substrate can be excessively thinned.

Further, if the transfer time of the silicon substrate after tapping the molten silicon from the molten silicon storage unit is less than 0.5 seconds, the manufactured silicon substrate can be excessively thinned. On the contrary, if the transfer time of the silicon substrate after tapping exceeds 3.5 seconds, the silicon substrate can be excessively thickened, thereby making it impossible to perform continuous casting.

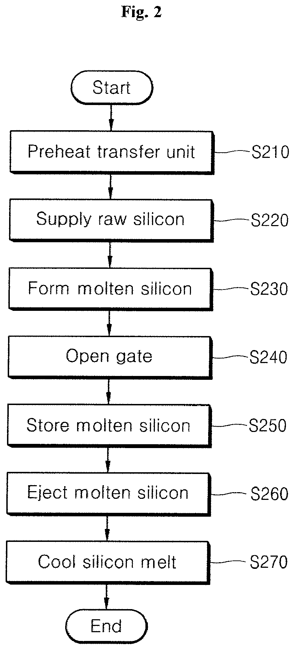

Fig. 2 is a flowchart of a method of manufacturing a silicon substrate using inert gas blowing according to one exemplary embodiment of the present invention.

Referring to Fig. 2, the silicon substrate manufacturing method using inert gas blowing includes preheating a transfer unit in S210, supplying raw silicon in S220, forming molten silicon in S230, opening a gate in S240, storing the molten silicon in S250, ejecting the molten silicon in S260, and cooling a silicon melt in S270.

In operation S210 of preheating the transfer unit, the transfer unit disposed at one side of a lower portion of a molten silicon storage unit is preheated. Here, the preheating temperature of the transfer unit may be in the range of 750∼1400°C. If the preheating temperature of the transfer unit is less than 750°C, the molten silicon can be solidified at a contact portion between the transfer unit and the molten silicon. On the contrary, if the preheating temperature of the transfer unit exceeds 1400°C, the silicon melt can trickle down.

The transfer unit may be made of a material that has good wettability, high corrosion resistance and a higher melting point than that of silicon. Further, in order to guarantee easy separation of the silicon substrate after cooling, the transfer unit may be made of a material having a different coefficient of thermal expansion than silicon. Specifically, the transfer unit may be made of at least one material selected from C, SiC, Si₃N₄, graphite, Al₂O₃ and Mo.

Operation S210 of preheating the transfer unit may be performed before operation S240 of opening the gate or operation S250 of storing the molten silicon. In the method according to this embodiment, preheating of the transfer unit is not necessarily performed at an initial stage of the method and may be performed by various selective methods as needed.

In operation S220 of supplying raw silicon, a predetermined amount of raw silicon is supplied into a silicon melting unit through a raw silicon feeder.

In operation S230 of forming molten silicon, the raw silicon placed in the silicon melting unit is melted to form molten silicon. The raw silicon may be melted through induction melting. In this case, the silicon melting unit may include a crucible that receives the raw silicon and has a tapping hole formed at a lower side thereof, an induction coil wound around an outer wall of the crucible, and a gate opening or closing the tapping hole.

In operation S240 of opening the gate, the gate is opened to tap the molten silicon from the silicon melting unit.

In operation S250 of storing the molten silicon, the molten silicon tapped from the silicon melting unit is stored. In the molten silicon storage unit, the surface temperature of the molten silicon may be kept in the range of 1350∼1500°C. If the surface temperature of the molten silicon stored in the molten silicon storage unit is less than 1350°C, the molten silicon can solidify before tapping. If the surface temperature of the molten silicon exceeds 1500°C, the silicon melt can trickle down during transfer of the tapped silicon melt.

In operation S260 of ejecting the molten silicon, the transfer unit is driven in the horizontal direction to eject the molten silicon through an ejection port.

At this time, the moving speed of the transfer unit may be in the range of 450∼1400 cm/min, and the transfer time of the silicon substrate after tapping the molten silicon from the molten silicon storage unit may be in the range of 0.5∼3.5 seconds.

If the moving speed of the transfer unit is less than 450 cm/min, the manufactured silicon substrate can be excessively thickened. If the moving speed of the transfer unit exceeds 1400 cm/min, the manufactured silicon substrate can be excessively thinned.

Further, if the transfer time of the silicon substrate after tapping the molten silicon from the molten silicon storage unit is less than 0.5 seconds, the manufactured silicon substrate can be excessively thinned. If the transfer time of the silicon substrate after tapping exceeds 3.5 seconds, the silicon substrate can be excessively thickened, thereby making it impossible to perform continuous casting.

In operation S270 of cooling a silicon melt, the silicon melt transferred by the transfer unit is cooled to form a silicon substrate.

At this time, cooling the silicon melt may be performed by inert gas blowing, and the inert gas may be argon, without being limited thereto. Alternatively, the inert gas blowing may be performed using helium, nitrogen, and the like.

Here, The inert gas may by blown at a rate of 0.1∼3 Nm³/h. More preferably, the inert gas is blown at a rate of 0.6∼2.5 Nm³/h. If the inert gas is blown at a rate less than 0.1 Nm³/h, the silicon substrate can be excessively thickened due to inefficient inert gas blowing, thereby making it impossible to perform continuous casting. On the other hand, if the inert gas is blown at a rate exceeding 3 Nm³/h, the silicon melt is blown, thereby making it impossible to obtain continuous manufacture of the silicon substrate.

In this manner, the method of manufacturing a silicon substrate using continuous casting according to the embodiment of the invention can be completed.

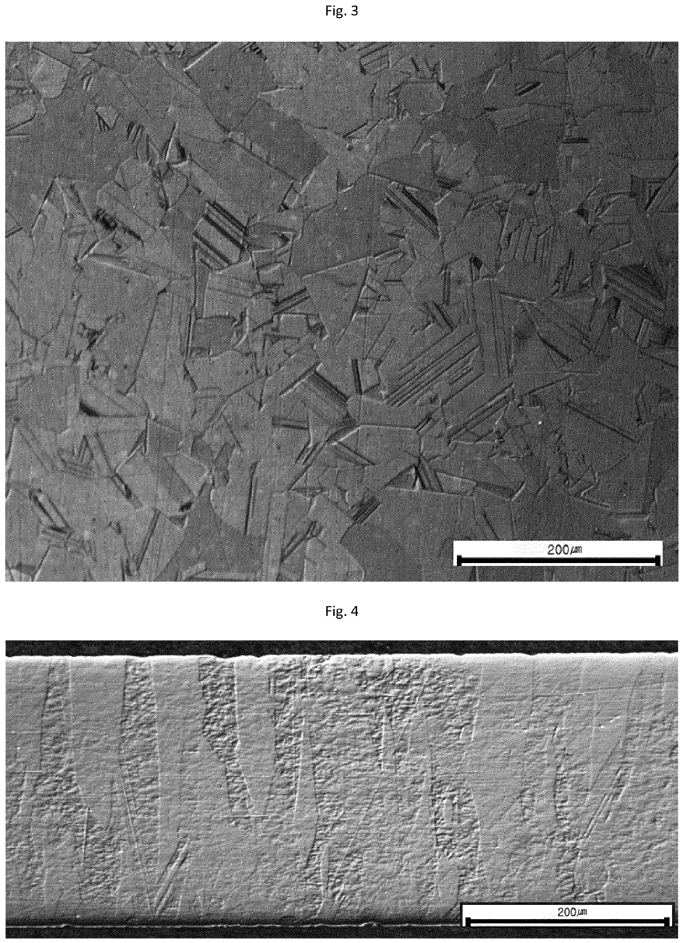

Fig. 3 is a micrograph showing the microstructure of a surface of a silicon substrate manufactured by the apparatus according to the exemplary embodiment and Fig. 4 is a micrograph showing the microstructure of a cross-section of the silicon substrate of Fig. 3.

In Figs. 3 and 4, it can be seen that the manufactured silicon substrate has a polycrystalline structure, an average grain size of 50∼100 µm, and a vertically grown columnar structure. When the silicon substrate having such a columnar structure is used for a solar cell, minor carriers excited by sunlight have increased lifetime, thereby improving cell efficiency.

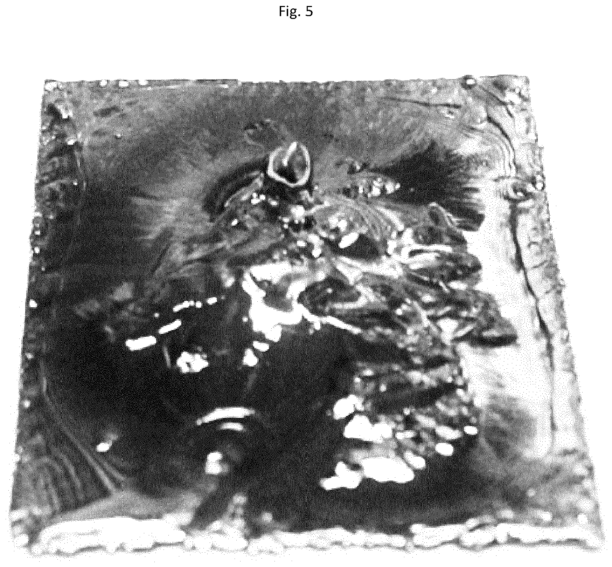

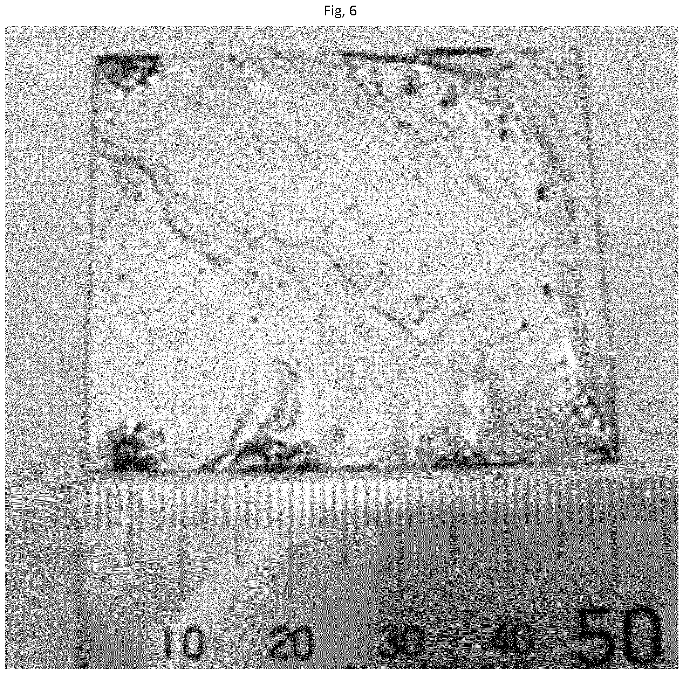

Fig. 5 is a picture showing the surface of a silicon substrate manufactured without application of inert gas blowing and Fig. 6 is a picture showing the surface of a silicon substrate manufactured using inert gas blowing.

Referring to Fig. 5, when the silicon melt is not subjected to inert gas blowing, the silicon substrate has a rough surface.

Silicon has a melt density of about 2.57 g/cm³ and a solid density of about 2.33 g/cm³. Since the solid density of silicon is lower than the melt density, silicon undergoes expansion during solidification and can have a rough surface in the case where the silicon undergoes non-uniform expansion, as shown in Fig. 5. As a result, the manufactured silicon substrate has low surface quality.

As shown in Fig. 6, however, when the silicon melt is subjected to inert gas blowing, specifically, argon gas blowing, the manufactured silicon substrate has excellent surface quality as compared to that shown in Fig. 5.

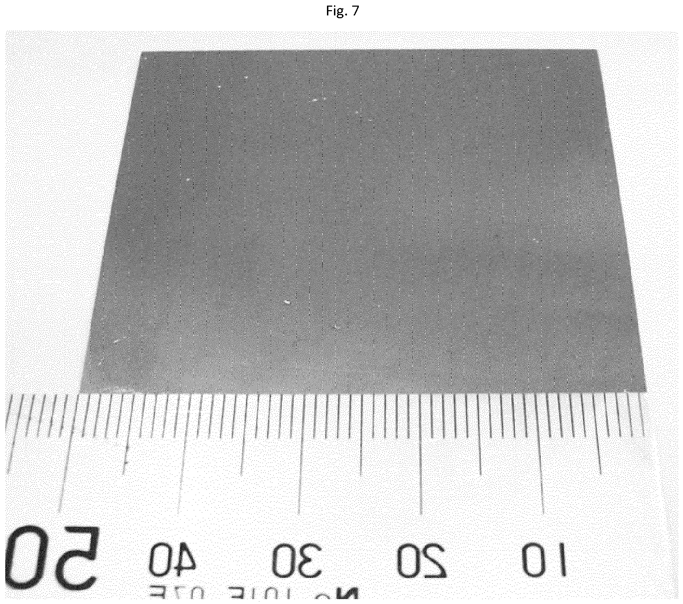

Fig. 7 is a picture showing a polished surface of the silicon substrate of Fig. 6.

The substrate for solar cells typically has a thickness of 100∼400 µm. Accordingly, when the silicon substrate manufactured by the method shown in Fig. 7 is adjusted to have a thickness of 100∼400 µm, the silicon substrate may be used for solar cells.

As such, the apparatus and method according to the embodiments of the invention may improve productivity of a silicon substrate through inert gas blowing during continuous casting, which has excellent productivity and facilitates property control.

Accordingly, the silicon substrate manufactured using the apparatus and method according to the embodiments has excellent surface quality to be suited for solar cells.

### Examples

Next, the present invention will be described in detail with reference to illustrative examples. However, it should be understood that the present invention is not limited to the following examples. A description of details apparent to a person having ordinary knowledge in the art will be omitted.

Table 1 shows the thicknesses and shapes of silicon substrates prepared by conditions of Examples 1 to 4 and Comparative Example 1.

**Table 1**

| | Preheating temperature (°C) | Moving speed (cm/min) | Transfer time after tapping (second) | Blowing rate of argon (Nm³/h) | Substrate thickness (µm) | Substrate shape |
|---|---|---|---|---|---|---|
| Example 1 | 1,000 | 485 | 2.5 | 0.5 | 852 | Bad |
| Example 2 | 1,000 | 485 | 2.5 | 0.65 | 320 | Good |
| Example 3 | 1,000 | 485 | 2.5 | 0.8 | 278 | Good |
| Example 4 | 1,000 | 485 | 2.5 | 1.1 | 258 | Good |
| Comparative example 1 | 1,000 | 485 | 2.5 | 3.0 | - | Bad |

Referring to Table 1, Examples 1 to 4 were prepared to determine a relationship between the thickness and shape of the manufactured substrate and the blowing amount of argon. In Examples 1 to 4, it was ascertained that the thickness of the substrate decreased with increasing blowing rate of argon.

Here, it could be seen from Example 1 that the silicon substrate was excessively thickened due to inefficient inert gas blowing when the blowing rate of argon was 0.5 Nm³/h, and that a desired effect of inert gas blowing was obtained from a blowing rate of argon of 0.65 Nm³/h or more.

Even when manufacture of the silicon substrate becomes difficult due to an undesired blowing rate of inert gas, continuous manufacture of the silicon substrate can be obtained by adjusting other process variables, such as the preheating temperature of the transfer unit, the moving speed of the transfer unit, and the transfer time of the substrate after tapping the molten silicon.

On the contrary, when the argon gas was blown at a high rate of 3.0 Nm³/h as in Comparative Example 1, the silicon substrate was blown during manufacture thereof, thereby making it impossible to obtain continuous manufacture of the silicon substrate.

Although some embodiments have been described herein, it should be understood by those skilled in the art that these embodiments are given by way of illustration only, and that various modifications, variations, and alterations can be made without departing from the spirit and scope of the invention. Therefore, the scope of the invention should be limited only by the accompanying claims and equivalents thereof.

## Claims

1. An apparatus for manufacturing a silicon substrate using inert gas blowing, comprising:
a raw silicon feeder through which raw silicon is fed;
a silicon melting unit disposed under the raw silicon feeder and melting the raw silicon to form molten silicon;
a molten silicon storage unit storing the molten silicon supplied from the silicon melting unit and tapping the molten silicon to provide a silicon melt having a constant thickness;
a transfer unit transferring the silicon melt tapped from the molten silicon storage unit; and
a cooling unit cooling the silicon melt transferred by the transfer unit,
wherein the cooling unit cools the silicon melt by blowing inert gas at a rate of 0.1∼3 Nm³/h, the transfer unit defines a lower surface of the molten silicon storage unit, a preheating temperature of the transfer unit is in the rage of 750∼1400 °C and a moving speed of the transfer unit is in the range of 450∼1400 cm/min, and a transfer time of the silicon substrate after tapping the molten silicon from the molten silicon storage unit is in the range of 0.5∼3.5 seconds.

2. The apparatus of claim 1, wherein the inert gas is at least one selected from the group of argon, helium, nitrogen, and mixtures thereof.

3. The apparatus of claim 1, wherein the silicon melting unit comprises a crucible receiving the raw silicon supplied from the raw silicon feeder and having a tapping hole formed at a lower side thereof, an induction coil wound around an outer wall of the crucible, and a gate opening or closing the tapping hole.

4. The apparatus of claim 3, wherein the silicon melting unit melts the raw silicon through induction melting.

5. The apparatus of claim 1, wherein the molten silicon stored in the molten silicon storage unit has a surface temperature of 1350∼1500 °C.

6. The apparatus of claim 1, wherein the molten silicon storage unit is formed at one side of a lower portion thereof with an ejection port through which the molten silicon is ejected.

7. A method of manufacturing a silicon substrate using the apparatus of claim 1, comprising:
supplying raw silicon into the silicon melting unit;
melting the raw silicon placed in the silicon melting unit to form molten silicon;
opening a gate of the silicon melting unit to tap the molten silicon;
storing the tapped molten silicon in the molten silicon storage unit;
driving the transfer unit to eject the molten silicon;
cooling the molten silicon by blowing inert gas to the molten silicon transferred by the transfer unit, the inert gas being blown at a rate of 0.1∼3 Nm³/h, wherein the method further comprising
preheating the transfer unit to 750∼1400 °C before supplying the raw silicon into the silicon melting unit
and wherein
in driving the transfer unit to eject the molten silicon, the transfer unit is moved at a speed of 450∼1400 cm/min and a transfer time of the silicon substrate after tapping the molten silicon is 0.5∼3.5 seconds.

8. The method of claim 7, wherein the molten silicon is kept at a surface temperature of 1350∼1500 °C in the molten silicon storage unit.

9. The method of claim 7, wherein the inert gas is at least one selected from the group of argon, helium, nitrogen, and mixtures thereof.

## Patentansprüche

1. Vorrichtung zum Herstellen eines Siliziumsubstrats unter Verwendung von Inertgas-Einblasung, umfassend:
eine Zuführvorrichtung für rohes Silizium, durch die rohes Silizium zugeführt wird;
eine Silizium-Schmelzeinheit, die unter der Zuführvorrichtung für rohes Silizium angeordnet ist und das rohe Silizium schmilzt, um geschmolzenes Silizium zu bilden;
eine Speichereinheit für geschmolzenes Silizium, die das geschmolzene Silizium, das von der Silizium-Schmelzeinheit bereitgestellt wird, speichert und das geschmolzene Silizium absticht, um eine Siliziumschmelze mit einer konstanten Dicke bereitzustellen;
eine Übertragungseinheit, die die von der Speichereinheit für geschmolzenes Silizium abgestochene Siliziumschmelze überträgt; und
eine Kühleinheit, die die von der Übertragungseinheit übertragene Siliziumschmelze kühlt,
wobei die Kühleinheit die Siliziumschmelze durch Einblasen von Inertgas bei einer Flussmenge von 0,1∼3 Nm³/h kühlt, die Übertragungseinheit eine untere Oberfläche der Speichereinheit für geschmolzenes Silizium definiert, eine Vorheiztemperatur der Übertragungseinheit im Bereich von 750∼1400 °C liegt und eine Bewegungsgeschwindigkeit der Übertragungseinheit im Bereich von 450∼1400 cm/min liegt und eine Übertragungszeit des Siliziumsubstrats nach dem Abstechen des geschmolzenen Siliziums von der Speichereinheit für geschmolzenes Silizium im Bereich von 0,5∼3,5 Sekunden liegt.

2. Vorrichtung nach Anspruch 1, wobei das Inertgas zumindest eines ausgewählt aus der Gruppe von Argon, Helium, Stickstoff und Gemischen davon ist.

3. Vorrichtung nach Anspruch 1, wobei die Silizium-Schmelzeinheit einen Tiegel umfasst, der das rohe Silizium empfängt, das von der Zuführvorrichtung für rohes Silizium bereitgestellt wird, und über ein Abstechloch, das an einer unteren Seite davon ausgebildet ist, eine Induktionsspule, die um die äußere Wand des Tiegels gewickelt ist, und einen Verschluss, der das Abstechloch öffnet oder schließt, verfügt.

4. Vorrichtung nach Anspruch 3, wobei die Silizium-Schmelzeinheit das rohe Silizium durch Induktionsschmelzen schmilzt.

5. Vorrichtung nach Anspruch 1, wobei das in der Speichereinheit für geschmolzenes Silizium gespeicherte geschmolzene Silizium eine Oberflächentemperatur von 1350∼1500 °C hat.

6. Vorrichtung nach Anspruch 1, wobei die Speichereinheit für geschmolzenes Silizium an einer Seite eines unteren Abschnitts davon mit einer Ausstoßöffnung, durch die das geschmolzene Silizium ausgestoßen wird, ausgebildet ist.

7. Verfahren zum Herstellen eines Siliziumsubstrats unter Verwendung der Vorrichtung nach Anspruch 1, umfassend:
Bereitstellen von rohem Silizium in die Silizium-Schmelzeinheit;
Schmelzen des rohen Siliziums, das in der Silizium-Schmelzeinheit platziert ist, um geschmolzenes Silizium zu bilden;
Öffnen eines Verschlusses der Silizium-Schmelzeinheit, um das geschmolzene Silizium abzustechen;
Speichern des abgestochenen geschmolzenen Siliziums in der Speichereinheit für geschmolzenes Silizium;
Antreiben der Übertragungseinheit, um das geschmolzene Silizium auszustoßen;
Kühlen des geschmolzenen Siliziums durch Einblasen von Inertgas zu dem geschmolzenen Silizium, das durch die Übertragungseinheit übertragen wird, wobei das Inertgas mit einer Flussmenge von 0,1∼3 Nm³/h eingeblasen wird, wobei das Verfahren ferner Folgendes umfasst:
Vorheizen der Übertragungseinheit auf 750∼1400 °C, bevor das rohe
Silizium in die Silizium-Schmelzeinheit bereitgestellt wird,
und wobei
beim Antreiben der Übertragungseinheit, um das geschmolzene Silizium auszustoßen, die Übertragungseinheit mit einer Geschwindigkeit von 450∼1400 cm/min bewegt wird und eine Übertragungszeit des Siliziumsubstrats nach dem Abstechen des geschmolzenen Silizium 0,5∼3,5 Sekunden beträgt.

8. Verfahren nach Anspruch 7, wobei das geschmolzene Silizium auf einer Oberflächentemperatur von 1350∼1500 °C in der Speichereinheit für geschmolzenes Silizium gehalten wird.

9. Verfahren nach Anspruch 7, wobei das Inertgas zumindest eines ausgewählt aus der Gruppe von Argon, Helium, Stickstoff und Gemischen davon ist.

## Revendications

1. Appareil de fabrication d'un substrat en silicium à l'aide d'un soufflage à gaz inerte, comprenant :
un dispositif d'alimentation en silicium brut à travers lequel du silicium brut est fourni ;
une unité de fusion de silicium disposée sous le dispositif d'alimentation en silicium brut et la fusion du silicium brut pour former le silicium fondu ;
une unité de stockage de silicium fondu stockant le silicium fondu provenant de l'unité de fusion de silicium et en coulant le silicium fondu pour fournir une fonte de silicium possédant une épaisseur constante ;
une unité de transfert transférant le silicium fondu coulé à partir de l'unité de stockage de silicium fondu ; et
une unité de refroidissement refroidissant la fonte de silicium transféré par l'unité de transfert,
ladite unité de refroidissement refroidissant le silicium fondu en soufflant un gaz inerte à un débit de 0,1 à 3 Nm³/h, ladite unité de transfert définissant une surface inférieure de l'unité de stockage de silicium fondu, une température de préchauffage de l'unité de transfert étant comprise dans la plage allant de 750 à 1400°C et une vitesse de déplacement de l'unité de transfert étant comprise dans la plage allant de 450 à 1400 cm/min et un temps de transfert du substrat de silicium après coulage du silicium fondu depuis l'unité de stockage de silicium fondu étant compris dans la plage allant de 0,5 à 3,5 secondes.

2. Appareil selon la revendication 1, ledit gaz inerte étant au moins l'un choisi dans le groupe constitué par l'argon, l'hélium, l'azote et des mélanges de ceux-ci.

3. Appareil selon la revendication 1, ladite unité de fusion de silicium comprenant un creuset recevant le silicium brut fourni depuis le dispositif d'alimentation en silicium brut et possédant un trou de coulée formé sur un côté inférieur de celui-ci, une bobine d'induction enroulée autour d'une paroi externe du creuset et une vanne ouvrant ou fermant le trou de coulée.

4. Appareil selon la revendication 3, ladite unité de fusion de silicium faisant fondre le silicium brut à l'aide d'une fusion par induction.

5. Appareil selon la revendication 1, ledit silicium fondu stocké dans l'unité de stockage de silicium fondu possédant une température de surface allant de 1350 à 1500°C.

6. Appareil selon la revendication 1, ladite unité de stockage de silicium fondu étant dotée au niveau d'un côté d'une partie inférieure de celle-ci d'un orifice d'éjection à travers lequel le silicium fondu est éjecté.

7. Procédé de fabrication d'un substrat de silicium à l'aide de l'appareil selon la revendication 1, comprenant :
la fourniture de silicium brut dans l'unité de fusion de silicium ;
la fusion du silicium brut placé dans l'unité de fusion de silicium pour former du silicium fondu ;
l'ouverture d'une vanne de l'unité de fusion de silicium afin de couler le silicium fondu ;
le stockage du silicium fondu coulé dans l'unité de stockage de silicium fondu ;
l'entraînement de l'unité de transfert pour éjecter le silicium fondu ;
le refroidissement du silicium fondu en soufflant un gaz inerte vers le silicium fondu transféré par l'unité de transfert, le gaz inerte étant soufflé à un débit allant de 0,1 à 3 Nm³/h, ledit procédé comprenant en outre
le préchauffage de l'unité de transfert à une température allant de 750 à 1400°C avant de fournir le silicium brut dans le unité de fusion de silicium
et
l'entraînement de l'unité de transfert pour éjecter le silicium fondu, ladite unité de transfert étant déplacée à une vitesse allant de 450 à 1400 cm/min et le temps de transfert du substrat en silicium après la coulée du silicium fondu étant de 0,5 à 3,5 secondes.

8. Procédé selon la revendication 7, ledit silicium fondu étant maintenu à une température de surface allant de 1350 à 1500°C dans l'unité de stockage de silicium fondu.

9. Procédé selon la revendication 7, ledit gaz inerte étant au moins l'un choisi dans le groupe constitué par l'argon, l'hélium, l'azote et des mélanges de ceux-ci.
